# EUROPÄISCHE PATENTSCHRIFT

(11) **EP 0 534 114 B1**
(45) Veröffentlichungstag und Bekanntmachung des Hinweises auf die Patenterteilung: **18.10.1995**
(21) Anmeldenummer: 92113679.2
(22) Anmeldetag: 11.08.1992
(51) Int. Cl.: H02H 11/00, H02H 7/26, G01R 27/16, H02H 3/00

(54) **Analoge Anordnung zur schnellen Kurzschlussdetektion**
Analog array for fast detection of short-circuits
Disposition analogue pour la reconnaissance rapide de court-circuit

(30) Priorität: 28.08.1991 DE 4128618
(43) Veröffentlichungstag der Anmeldung: 31.03.1993
(73) Patentinhaber: SIEMENS AKTIENGESELLSCHAFT, 80333 München (DE)
(72) Erfinder: Nippert, Thomas, Dipl.-Ing., W-2000 Hamburg 70 (DE); Trenkler, Gerhard, Prof.Dr. Ing., W-2000 Hamburg-Barsbüttel (DE); Maier, Reinhard, Dr., W-8522 Herzogenaurach (DE)

(56) Entgegenhaltungen:
- DE-A- 3 347 185
- DE-A- 3 347 209
- DE-A- 3 626 400

## Beschreibung

Die Erfindung bezieht sich auf eine Anordnung zur schnellen Erkennung von Kurzschlüssen und zur Erzeugung eines elektrischen Auslösebefehls mit einer elektronischen Meß- und Verarbeitungsanordnung zur Messung und zur Verarbeitung der zeitlichen Verlaufe von Strom und Spannung, und mit einer Vergleichsschaltung, die die gemessenen und verarbeiteten Strom- und Spannungswerte mit voreingestellten Meßwerten vergleicht, wobei davon abhängig die Meß- und Verarbeitungsanordnung einen Auslösebefehl abgibt und wobei die Meßanordnung aus den zeitlichen Verläufen des Stromes und der Spannung des Netzes die komplexen Leistungen und Impedanzen ermittelt.

Bei einer bekannten Anordnung der obengenannten Art (DE-OS 36 26 400) werden die Zeitverläufe von Strom und Spannung beispielsweise in einer Digital-Vergleichsschaltung in digitale Zeitreihen umgesetzt, diese digitalen Zahlenfolgen in eine zeitliche Folge von Segmenten zerlegt und durch Anwenden der diskreten Fouriertransformation auf die Zeitverläufe der Segmente in den Frequenzbereich transformiert. Mit den Fouriertransformierten der Segmente erfolgt dann die Berechnung der komplexen Produkte und Quotienten, die zur Anlagenklassifikation benutzt werden. Alle Berechnungen einschließlich der Bildung der Fouriertransformierten werden mit digitalen Funktionsbausteinen durchgeführt. Für eine schnelle Klassifikation sind Frequenzkomponenten in Strom und Spannung notwendig, die erheblich über der Netzfrequenz liegen. Für eine schnelle und sichere Auswertung dieser Frequenzkomponenten werden digitale Funktionsbausteine mit hoher Leistungsfähigkeit benötigt, was einen hohen finanziellen Aufwand bedeutet, außerdem bildet eine solche Anordnung der obengenannten Art ein sehr komplexes System, das einen großen Entwicklungsaufwand zur Sicherstellung einer geringen Falschalarmrate erfordert. Aus den genannten Grunden ist ein Einsatz dieser Anordnung nur an wenigen exponierten Stellen eines Verteilungsnetzes für elektrische Energie sinnvoll.

Der vorliegenden Erfindung liegt die Aufgabe zugrunde, eine Anordnung der obengenannten Art zu schaffen, bei der unter Vermeidung der beschriebenen Nachteile das Verhalten der überwachten Sammelschienenabzweige im Betriebszustand sowie im Kurzschlußfall auf einfache Weise feststellbar sind.

Dies wird auf einfache Weise dadurch erreicht, daß die Vergleichsschaltung sowie die Leistungs- und Impedanzermittlung aus analogen Funktionsbausteinen bestehen und daß eine Anordnung vorhanden ist, die die zeitlichen Verläufe von Strom und Spannung mit jeweils zwei Trägersignalen linear amplitudenmoduliert und daß die Frequenz der Trägersignale gleich der Mittenfrequenz der zur Selektion vorbestimmten Frequenzbänder ist.

Es ist an sich eine Anordnung zur Beeinflussung eines Schaltgerätes in Abhängigkeit von Netzzustandsdaten durch eine Impedanzmeßeinrichtung mit einer Verarbeitungsstufe, die in Abhängigkeit von vorgegebenen Impedanzwerten die Einschaltung des Schaltgerätes blockiert, bekannt (DE-OS 33 47 209), jedoch gibt die hier vorgenommene Impedanzmessung keine Angaben über die umgesetzten Leistungen.

Eine Basisbandumsetzung oder Synchrongleichrichtung ist an sich bekannt (F. Arnold, Elektronische Meßtechnik, Verlag W. Kohlhammer, S. 131f).

Es ist für die Bestimmung der Leitwerte und Leistungsansätze bestimmter Frequenzbereiche vorteilhaft, wenn eine Anordnung zur Filterung des gemessenen Stromes und der gemessenen Spannung vor den folgenden Untersuchungen vorhanden ist, deren Mittenfrequenz die Frequenz der Trägersignale ist. Hiermit ist auch zu vermeiden, daß elektronische Störungen in die Auswertung gelangen. Das Filtern von Meßwerten ist an sich bekannt (8047 IEEE Trans. on Power apparatus & syst., Vol. 1 PAS-99, 1980 Jan./Feb., No.1, S. 153). Um eine einfache Bestimmung der Real- und Imaginärteile der komplexen Leistungen ermöglichen, ist es von Vorteil, wenn eine Anordnung vorhanden ist, die zur Modulation des Strom- bzw. Spannungsverlaufs zwei um T/4 verschobene Trägersignale erzeugt. Zweiseitenbandamplitudenmodulation mit unterdrücktem Träger sowie Quadraturmodulation sind an sich bekannt (R. Mäusl, Modulationsverfahren der Nachrichtentechnik, Hüthig-Verlag, S. 26f bzw. S. 68f). Die Erzeugung der Trägersignale wird besonders einfach, wenn Rechteckfunktionen als Trägersignale vorgesehen sind.

Die Berechnung der Real- und Imaginärteile der Leistungen wird einfacher, wenn eine Anordnung vorhanden ist, die die bei der linearen Amplitudenmodulation entstehenden oberen Seitenbänder unterdrückt. Es ist für die Bestimmung des Anlagenzustandes vorteilhaft, wenn in einer Anordnung die komplexen Leistungen und Impedanzen mit analogen Funktionsbausteinen nach Amplitudenmodulation der Signale von Strom und Spannung berechnet werden. Diese Bestimmung wird besonders einfach und die Detektionssicherheit erhöht, wenn mehrere Anordnungen vorgesehen sind, die aus mehreren selektierten Frequenzbändern parallel die komplexen Leitwerte und Leistungen bestimmen, die auf eine Anordnung zur Bewertung der komplexen Leitwerte und Leistungen der selektierten Frequenzbänder wirken.

Anhand der Zeichnung wird ein Ausführungsbeispiel gemaß der Erfindung beschrieben.

Es zeigen:
- FIG 1: schematisch einen durch einen Leistungsschalter geschützten Abgang mit n Verbrauchern,
- FIG 2: ein Signalverarbeitungsschema gemäß der Erfindung.

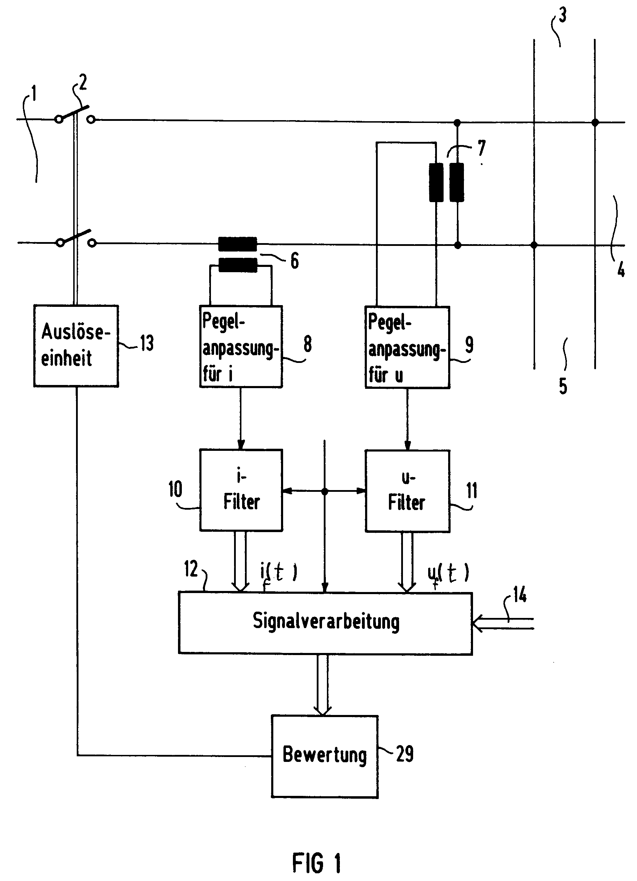

Der in FIG 1 dargestellte Niederspannungsabgang ist an die Niederspannungsverteilung 1 über den Leistungsschalter 2 angeschaltet. Im Ausführungsbeispiel sind die Verbraucher 3, 4 und 5 angedeutet. Der Strom i nach dem Leistungsschalter 2 wird über einen Stromwandler 6 und die Spannung u des Anlagenteiles über einen Spannungswandler 7 erfaßt. Die an die Sekundärseiten des Strom- bzw. Spannungswandlers angeschlossenen Anordnungen 8 und 9 sorgen für die Anpassung der Pegel an die Aussteuerbereiche der nachfolgenden elektronischen Funktionsbausteine. Die Filter 10 und 11, die aus den Zeitverläufen von Strom und Spannung ein bestimmtes Frequenzband selektieren sollen, stehen mit einer Signalverarbeitungsschaltung 12 in Verbindung, die ihrerseits über eine Bewertungsschaltung 29 auf eine Auslöseeinheit 13 einwirkt, die mit dem Leistungsschalter 2 in Verbindung steht. Der Leistungsschalter 2 kann dabei auch ein elektronischer Schalter, beispielsweise ein Thyristor sein. Die Voreinstellung für die Signalverarbeitungsschaltung 12 ist durch einen Pfeil 14 angedeutet. In der Signalverarbeitungsschaltung 12 wird mittels festprogrammierbarer Bauelemente eine Identifikation und Klassifizierung der hinter den Wandlern 6, 7 vorhandenen Anlagenzustände anhand von geeigneten Parametern durchgeführt, wobei nach einem Vergleich mit den voreingestellten Parametern nach Bewertung auf Kurzschluß erkannt und ein Befehl zum Auslösen des Leistungsschalters erzeugt wird.

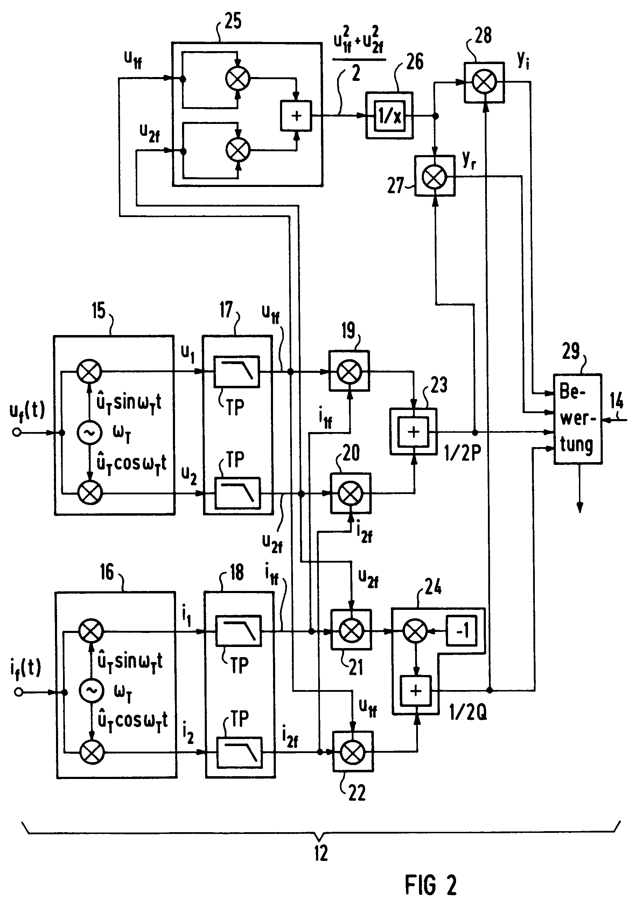

Eine mögliche Wirkungsweise der Signalverarbeitung 12 ist in FIG 2 dargestellt. Zuerst werden die gefilterten Zeitverläufe u_{f}(t), i_{f}(t) in den Funktionsblöcken 15 und 16 jeweils mit den beiden um T/4 gegeneinander verschobenen Trägersignalen, im Beispiel sind sie als Sinus- und Cosinusfunktion dargestellt, multipliziert. Die Ausgangssignale u₁, u₂, i₁ und i₂ sind also Produkte einer Zweiseitenbandamplitudenmodulation mit unterdrücktem Träger. Diese Modulationsprodukte durchlaufen dann die Filtereinheiten 17 und 18, um die bei der Amplitudenmodulation entstandenen oberen Seitenbänder zu eliminieren. Die Ausgangssignale i_{2f}, u_{2f} dieser Tiefpaßfilter lassen sich dabei als Realteile, die Ausgangssignale i_{1f}, u_{1f} als Imaginärteile der durch die Bandfilter 10 und 11 selektierten Frequenzbänder interpretieren. Durch die Bildung der Produkte u_{1f}, i_{1f} bzw. u_{2f}, i_{2f}, dargestellt in den Kästen 19 und 20 und Addition dieser Produkte im Funktionsblock 23 wird die Wirkleistung, durch Subtraktion des im Funktionsblock 21 gebildeten Produktes u_{2f}, i_{1f} von dem im Funktionsblock 22 gebildeten Produkt u_{1f}, i_{2f}, dargestellt im Kasten 24, die Blindleistung berechnet. Im Funktionsblock 25 werden u_{1f} und u_{2f} quadriert und addiert, im Funktionsblock 26 wird der Reziprokwert dieser Summe gebildet. Durch Multiplikation der Wirk- bzw. Blindleistung mit diesem Reziprokwert erfolgt die Berechnung von Real- und Imaginärteil des Leitwerts, dargestellt in den Kästen 27 und 28. Die Bewertung der so berechneten Parameter durch Vergleich mit den voreingestellten Grenzwerten, dargestellt durch den Pfeil 14, wird im Funktionsblock 29 vorgenommen, so daß im Kurzschlußfall ein Auslösebefehl für den Leistungsschalter abgegeben wird.

## Patentansprüche

1. Anordnung zur schnellen Erkennung von Kurzschlüssen und zur Erzeugung eines elektrischen Auslösebefehls mit einer elektronischen Meß- und Verarbeitungsanordnung zur Messung und zur Verarbeitung der zeitlichen Verläufe von Strom und Spannung, und mit einer Vergleichsschaltung (29), die die gemessenen und verarbeiteten Strom- und Spannungswerte mit voreingestellten Meßwerten vergleicht, wobei davon abhängig die Meß- und Verarbeitungsanordnung einen Auslösebefehl abgibt und wobei die Meßanordnung aus den zeitlichen Verläufen des Stromes und der Spannung des Netzes die komplexen Leistungen (19-24) und Impedanzen (25-28) ermittelt, **dadurch gekennzeichnet**, daß die Vergleichsschaltung (29) sowie die Leistungs- und Impedanzenermittlung aus analogen Funktionsbausteinen bestehen und daß eine Anordnung (15,16) vorhanden ist, die die zeitlichen Verläufe von Strom und Spannung mit jeweils zwei Trägersignalen linear amplitudenmoduliert und daß die Frequenz der Trägersignale gleich der Mittenfrequenz von zur Selektion vorbestimmten Frequenzbändern von Strom und Spannung (10,11) ist.

2. Anordnung nach Anspruch 1, **dadurch gekennzeichnet**, daß eine Anordnung zur Filterung (10, 11) des gemessenen Stromes und der gemessenen Spannung vor den folgenden Untersuchungen vorhanden ist, deren Mittenfrequenz die Frequenz der Trägersignale ist.

3. Anordnung nach Anspruch 1, 2 oder 3, **dadurch gekennzeichnet**, daß eine Anordnung (15, 16) vorhanden ist, die zur Modulation des Strom- bzw. Spannungsverlaufs zwei um T/4 verschobene Trägersignale erzeugt.

4. Anordnung nach einem der Ansprüche 1 - 4, **dadurch gekennzeichnet**, daß eine Anordnung (15, 16) vorhanden ist, die als Trägersignale Rechteckfunktionen erzeugt.

5. Anordnung nach einem der Ansprüche 1 - 5, **dadurch gekennzeichnet,** daß eine Anordnung (17, 18) vorhanden ist, die die bei der linearen Amplitudenmodulation entstehenden oberen Seitenbänder unterdrückt.

6. Anordnung nach einem der vorhergehenden Ansprüche, **dadurch gekennzeichnet**, daß in einer Anordnung (19, 20, 21, 22, 23, 24) die komplexen Leistungen und Impedanzen mit analogen Funktionsbausteinen nach Amplitudenmodulation der Signale von Strom und Spannung berechnet werden.

7. Anordnung nach einem der vorhergehenden Ansprüche, **dadurch gekennzeichnet**, daß mehrere Anordnungen (12) vorgesehen sind, die aus mehreren selektierten Frequenzbändern parallel die komplexen Leitwerte und Leistungen bestimmen, die auf eine Anordnung zur Bewertung der komplexen Leitwerte und Leistungen der selektierten Frequenzbänder wirken.

8. Anordnung nach einem der vorhergehenden Ansprüche, **dadurch gekennzeichnet**, daß eine Anordnung zur Bewertung der zeitlichen Verläufe der ermittelten komplexen Leistungen und Impedanzen vorhanden ist.

## Claims

1. Arrangement for the rapid detection of short circuits and for the generation of an electrical tripping command having an electronic measuring and processing arrangement to measure and process the temporal characteristics of current and voltage, and having a comparison circuit (29) which compares the measured and processed current and voltage values with preset measured values, whereby, dependent thereon, the measuring and processing arrangement emits a tripping command and whereby the measuring arrangement determines the complex outputs (19 - 24) and impedances (25 - 28) from the temporal characteristics of the current and the voltage of the system, characterized in that the comparison circuit (29) and the output and impedance determination consist of analog function blocks and in that an arrangement (15, 16) is present which amplitude-modulates in linear manner the temporal characteristics of current and voltage with two carrier signals in each case and in that the frequency of the carrier signals equals the mid-frequency of frequency bands of current and voltage (10, 11) predetermined for selection.

2. Arrangement according to claim 1, characterized in that an arrangement for filtering (10, 11) the measured current and the measured voltage before the subsequent tests is present, the mid-frequency of which is the frequency of the carrier signals.

3. Arrangement according to claim 1, 2 or 3, characterized in that an arrangement (15, 16) is present which generates two carrier signals out of phase by T/4 for the modulation of the current and voltage characteristic.

4. Arrangement according to one of claims 1 to 4, characterized in that an arrangement (15, 16) is present which generates square-wave functions as carrier signals.

5. Arrangement according to one of claims 1 to 5, characterized in that an arrangement (17, 18) is present which suppresses the upper sidebands occurring during the linear amplitude modulation.

6. Arrangement according to one of the preceding claims, characterized in that in an arrangement (19, 20, 21, 22, 23, 24) the complex outputs and impedances with analog function blocks are calculated after amplitude modulation of the signals of current and voltage.

7. Arrangement according to one of the preceding claims, characterized in that several arrangements (12) are provided, which determine from several selected frequency bands in parallel the complex conductances and outputs which act on an arrangement for the evaluation of the complex conductances and outputs of the selected frequency bands.

8. Arrangement according to one of the preceding claims, characterized in that an arrangement is present for the evaluation of the temporal characteristics of the determined complex outputs and impedances.

## Revendications

1. Dispositif de reconnaissance rapide de court-circuits et de production d'une instruction électrique de déclenchement, comportant un dispositif électronique de mesure et de traitement des courbes temporelles de courant et de tension et un circuit (29) de comparaison, qui compare les valeurs mesurées et traitées de courant et de tension à des valeurs de mesure réglées au préalable, les dispositifs de mesure et de traitement fournissant en fonction de cela une instruction de déclenchement et le dispositif de mesure déterminant à partir des courbes temporelles du courant et de la tension du réseau les puissances (19 à 24) complexes et impédances (25 à 28) complexes, caractérisé en ce que le circuit (29) de comparaison ainsi que le dispositif de détermination de puissance et d'impédance sont constitués de composants fonctionnels analogiques et un dispositif (15, 16), qui module en amplitude linéairement les courbes temporelles de courant et de tension par respectivement deux signaux porteurs, est prévu et la fréquence des signaux porteurs est égale à la fréquence médiane de bandes (10, 11) fréquencielles de courant et de tension prédéterminées pour la sélection.

2. Dispositif suivant la revendication 1, caractérisé en ce qu'un dispositif, qui est destiné au filtrage (10, 11) du courant mesuré et de la tension mesurée et dont la fréquence médiane est la fréquence des signaux porteurs, est prévu avant les traitements suivants.

3. Dispositif suivant la revendication 1 ou 2, caractérisé en ce qu'un dispositif (15, 16), qui produit pour la modulation de la courbe de courant ou de tension deux signaux porteurs décalés de T/4, est prévu.

4. Dispositif suivant l'une des revendications 1 à 3, caractérisé en ce qu'un dispositif (15, 16), qui produit comme signaux porteurs des fonctions rectangulaires, est prévu.

5. Dispositif suivant l'une des revendications 1 à 4, caractérisé en ce qu'un dispositif (17, 18), qui supprime les bandes latérales supérieures apparaissant lors de la modulation linéaire d'amplitude, est prévu.

6. Dispositif suivant l'une des revendications précédentes, caractérisé en ce que les puissances complexes et impédances complexes sont calculées dans un dispositif (19, 20, 21, 22, 23, 24) par des composants fonctionnels analogiques après modulation d'amplitude des signaux de courant et de tension.

7. Dispositif suivant l'une des revendications précédentes, caractérisé en ce que plusieurs dispositifs (12), qui déterminent en parallèle à partir de plusieurs bandes fréquencielles sélectionnées les valeurs complexes de conductivité et les puissances complexes et qui agissent sur un dispositif d'exploitation des valeurs complexes de conductivité et de puissances complexes des bandes fréquencielles sélectionnées, sont prévus.

8. Dispositif suivant l'une des revendications précédentes, caractérisé en ce qu'un dispositif d'exploitation des courbes temporelles des puissances et impédances complexes déterminées est prévu.
